# EUROPÄISCHE PATENTSCHRIFT

(11) **EP 0 788 683 B1**
(45) Veröffentlichungstag und Bekanntmachung des Hinweises auf die Patenterteilung: **12.08.1998**
(21) Anmeldenummer: 95934612.3
(22) Anmeldetag: 17.10.1995
(51) Int. Cl.: H03K 17/66

(54) **TREIBERSCHALTUNG**
DRIVER CIRCUIT
CIRCUIT D'ATTAQUE

(30) Priorität: 28.10.1994 DE 4438669
(43) Veröffentlichungstag der Anmeldung: 13.08.1997
(73) Patentinhaber: SIEMENS AKTIENGESELLSCHAFT, 80333 München (DE); SGS-THOMSON MICROELECTRONICS GMBH, 85630 Grasbrunn (DE)
(72) Erfinder: BRAKUS, Bogdan, D-82131 Stockdorf (DE); ROTH, Heinz-Jürgen, D-80469 München (DE)
(86) Internationale Anmeldenummer: DE9501440
(87) Internationale Veröffentlichungsnummer: WO9613901

(56) Entgegenhaltungen:
- EP-A- 0 620 646
- WO-A-93/01656
- DE-A- 2 612 495
- US-A- 4 251 742
- US-A- 5 296 760

## Beschreibung

Die Erfindung betrifft eine Treiberschaltung zur Ansteuerung einer Schalteinheit. Diese Treiberschaltung eignet sich insbesondere zum Einsatz in Schaltnetzteilen sowie zur Ansteuerung von Transistoren in Schaltumrichtern.
Eine derartige Treiberschaltung ist beispielsweise aus 301 Analog IC Designs, Ferranti Interdesign, Inc., 1987, Seite 113, Schaltungsbeispiel 260 bekannt.
Von Nachteil bei dieser Schaltungsanordnung ist es, daß niederohmige Eingangswiderstände einen hohen Stromverbrauch verursachen. Die bekannte Schaltungsanordnung weist weiter den Nachteil auf, daß für eine höhere Schaltfrequenz die Sink- und Sourceströme zu gering sind.

Der Erfindung liegt die Aufgabe zugrunde, eine Treiberschaltung für hohe Schaltfrequenzen anzugeben.

Diese erfindungsgemäße Aufgabe wird durch die kennzeichnenden Merkmale des Anspruchs 1 gelöst.

Die Erfindung bringt neben dem Vorteil, daß ein schneller high/low Flankenwechsel erreicht wird, die zusätzlichen Vorteile mit sich, daß ein geringer bias-Strombedarf zum Betreiben der Treiberschaltung benötigt wird sowie eine am Ausgang der Treiberschaltung gespeicherte Ladung zum Treiben der fallenden Flanke mit verwendet wird.

Eine vorteilhafte Weiterbildung der Erfindung ist es, daß bei einem einer Low-Phase entsprechendem Potential am Gate der Schalteinheit die volle Treiberleistung aktiv bleibt, dies bringt den Vorteil mit sich, daß bei induktiver Last ein zeitlich langer abklingender Strom, der am Drain des N-MOS Transistors über die parasitäre Drain-Gate Kapazität am Gate des Transistors wirksam ist, abgeleitet wird.

Eine vorteilhafte Ausgestaltung der Erfindung ist es, daß Mittel zum Umladen von parasitären Kapazitäten an den mit der Schaltungseinheit verbundenen schaltungsinternen Knoten vorgesehen sind. Das bringt den Vorteil mit sich, daß steilere Anstiegs- sowie Abfallflanken zur Ansteuerung des Gates des N-MOS Transistors erricht werden.

Eine weitere vorteilhafte Ausgestaltung ist, daß Mittel zur Reduzierung von Laufzeiten vorgesehen sind. Dies bringt den Vorteil mit sich, daß hohe Schaltfrequenzen und konstante Tastverhältnisse realisierbar sind.

Die Erfindung wird nachfolgend anhand von Figurenbeschreibungen sowie dazugehörigen Zeitdiagrammen eingehender erläutert.

Es zeigen:
- Fig. 1: ein Prinzipschaltbild,
- Fig. 2: eine schaltungstechnische Ausgestaltung sowie
- Fig. 3: a)ECL-Eingangssignal, 3b)N-MOS Treiberausgangssignal, c)Querströme des Treibers,
- Fig. 4: Spannungsverläufe an den Knoten 22, 4, 2,
- Fig. 5: Spannungsverläufe an den Knoten 9, 4, 60,
- Fig. 6: Spannungsverläufe an den Knoten 6, 8,
- Fig. 7: Spannungsverläufe an den Knoten 6, 8.

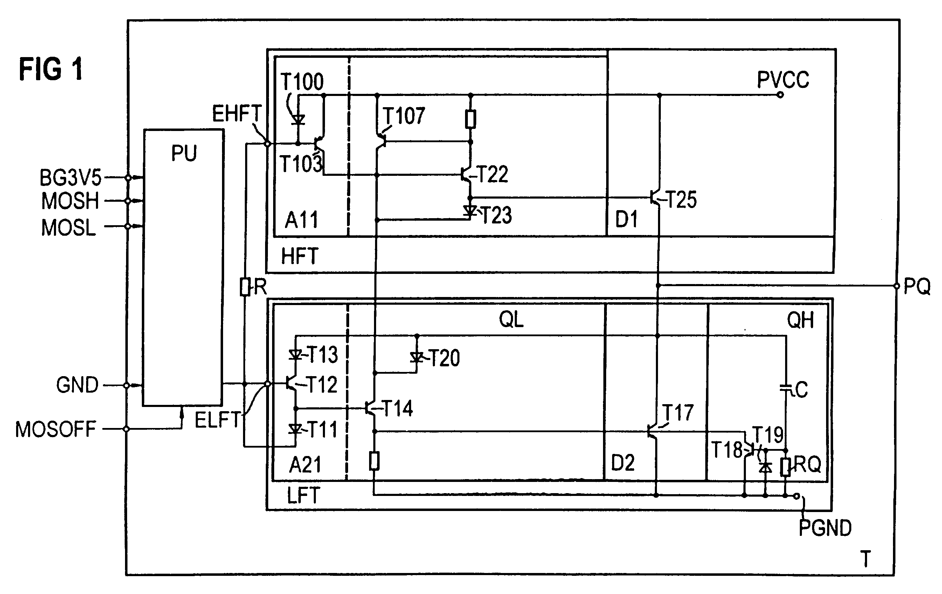

Fig. 1 zeigt schematisch in einem zum Verständis der Erfindung erforderlichem Umfang ein Prinzipschaltbild der Schaltungsanordnung eines Treibers T. Das Prinzipschaltbild der Treiberschaltungsanordnung T ist in eine Schaltungseinheit PU, einen ECL/N-MOS Pegelumsetzer, einem High-Flankentreiber HFT und einem Low-Flankentreiber LFT untergliedert. An den Treiber T sind im wesentlichen die nachfolgend aufgelisteten Anschlüsse angeordnet:
BG3V5 und GND sind die Versorgungsanschlüsse der Ansteuerschaltung des ECL/N-MOS Pegelumsetzers.
PVCC und PGND sind die Versorgungsanschlüsse der Treiberschaltung.
MOSH und MOSL sind die Signaleingangsanschlüsse und PQ ist der Ausgangsanschluß zur Ansteuerung des Gates eines N-MOS Transistors. Mit einem einem Low entsprechenden Potential an MOSOFF kann der Anschluß PQ low geschaltet werden. MOSOFF wird bei Power down-Funktion und bei vorgesehenen Störfunktionen in den low-Zustand geschaltet. Im low-Zustand von PQ ist die volle Treiberleistung vorhanden.

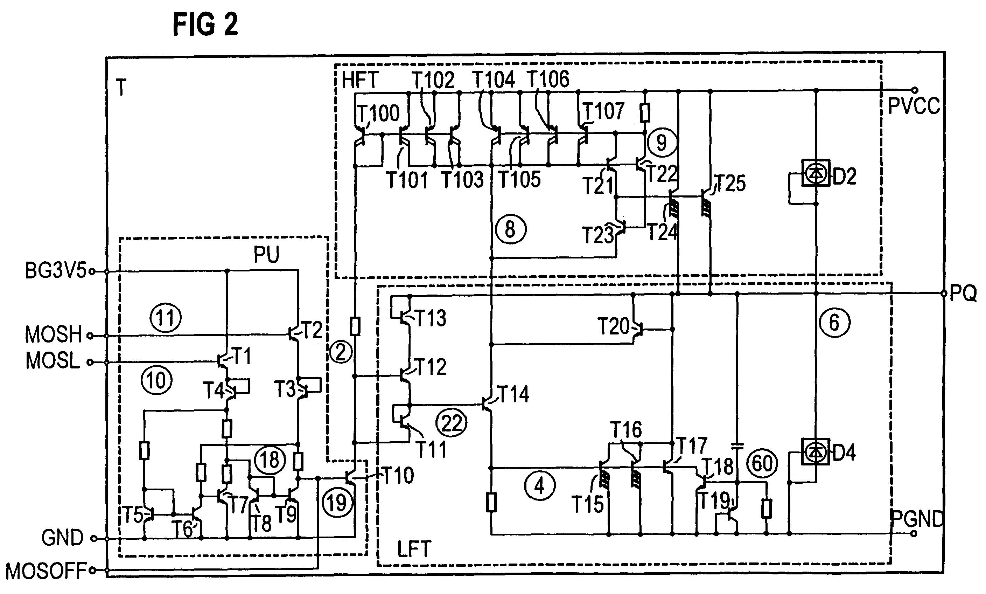

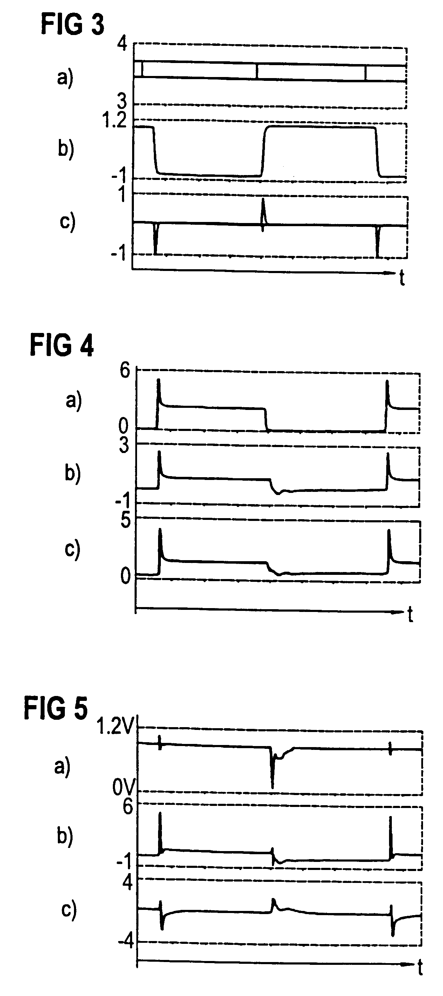

Fig. 2 zeigt eine schaltungstechnische Ausgestaltung der Treiberschaltung T. Diese in bipolar und N-MOS-Technologie herstellbare Treiberschaltung T zur Erzeugung schneller High-Low-Flanken mit geringem bias-Strombedarf eignet sich insbesondere zum Einsatz in Schaltnetzteilen sowie in Schaltumrichtern.
Nachfolgend wird die Funktionsweise der ECL/N-MOS Pegelumsetzung des Schaltkreises PU, die Signalfolge im Treiberausgang, die high-Flanke sowie die low-Flanke am Anschluß PQ im einzelnen anhand der Fig. 2 erläutert und durch die in den Figuren 3, 4 und 5 abgebildeten Signalverläufen verdeutlicht.

### ECL/N-MOS Pegelumsetzung im Schaltkreis PU:

Um schnelle Signale mit kleinem Hub zu übertragen, wird am Schaltungseingang MOSH-MOSL ein differentielles Signal von nur 320 mV benötigt. In Figur 3a sind beispielsweise ECL-Eingangssignale für die Knoten 10 und 11 des Ausführungsbeispiels von Figur 2 dargestellt.
T1 ... T10 dienen der Pegelumsetzung, wobei das differentielle Signal von 320 mV so umgesetzt wird, daß der Strom in der Basis von T10 über dessen Kollektor die Basis von T12 sicher auf GND-Potential ziehen kann. Zum anderen ist der Stromspiegel T8, T9 so ausgegelegt, daß T10 bei Einleitung der High-Flanke im Off-Zustand bleibt; der Strom durch die Kollektor-Basis-Kapazität von T10 wird nach GND abgeleitet, ohne in der Lage zu sein, T10 anzusteuern. Dies wird in der Schaltung durch ein unsymmetrisches Spiegelverhältnis von T9 zu T8 im Verhältnis 3 : 1 erreicht. In der On-Phase von T10 wird über die Transistoren T5, T6 und den Stromspiegelausgang T7 der Stromspiegeltransistor T8 abgeschaltet, so daß der gesamte vom Pegelumsetzer T1,..., T9 angebotene Strom in der Basis von T10 fließt.

### Treiberausgang:

Der Treiberausgang ist nur über den Kollektor von T10 mit der Pegelumsetzerschaltung verbunden und besteht aus einem Low-Flanken- und High-Flanken-Treiber, die sich gegenseitig so beeinflussen, daß der Querstrom in den Flanken zu Null gehalten wird. Als Querstrom wird der Strom betrachtet, der zwischen PVCC und PGND in den Transistoren T24, T25, T15, T16 und T17 fließt und der nicht in den Anschluß PQ fließt oder daraus entnommen wird, d.h., der High- oder Low-Flanke nicht zu gute kommt und somit ungenutzte Verlustleistung erzeugt. Da an dem Anschluß von PQ sich das Gate eines Leistungs-MOS-Transistors befindet, ist der Treiber so dimensioniert, daß er möglichst effektiv die kapazitive Last, die durch das Gate vorhanden ist, treiben kann und nach Beendigung der Flanke weiterhin den Low- oder High-Zustand aufrechterhält, bis von den Eingängen MOSH, MOSL eine Zustandsänderung erfolgt, da über parasitäre Kapazitäten am Gate zum Drain insbesondere bei induktiver Last auch außerhalb der Gate-Flanke Strom getrieben werden muß.

In Figur 3c sind die Querströme am Treiberausgang (Knoten 6) dargestellt. Mit der in Figur 2 angegebenen Schaltungsausgestaltung ist der Querstrom in der negativen Flanke von PQ Null. In der positiven Flanke von PQ ist nur für eine sehr kurze Zeit ein Querstrom vorhanden. Ersatzweise läßt sich eine solche Treiberanordnung durch zwei Schalter realisieren, die wechselweise PVCC und PGND mit PQ kurzschließen. In der Phase, wo der Schalter zwischen PVCC und PQ geschlossen ist, wird das Gate aufgeladen und der N-MOS Transistor geht in den On-Zustand. In der Phase, wo der Schalter zwischen PQ und PGND geschlossen ist, wird das Gate entladen und der N-MOS-Transistor geht in den Off-Zustand.

In der Treiberanordnung nach Figur 2 sind diese Schalter durch die Transistoren T11 ... T20 für den Low-Treiber und T21 ... T25, T100 ... T107 für den High-Treiber ausgeführt. Die Treiber HFT, LFT beeinflussen sich gegenseitig so, daß jeweils der aktive Treiber den nicht aktiven Treiber abschaltet und damit ein Fließen von Querströmen verhindert.

### High-Flanke an PQ:

Angenommen in der Basis von T10 fließt aus dem Stromspiegel T8, T9 Strom und der Kollektor von T10 zieht den 35K-Widerstand und die Basis von T12 nach GND, so spiegelt T100 den durch den Widerstand fließenden Strom in den Transistoren T101 ... T103 und die dreifach-Darlington Anordnung von T12, T14, T15 ... T17 wird deaktiviert. Dies bedeutet, daß die High-Flanke an PQ eingeleitet wird, da der Spiegelstrom an den Basen von T21, T22 fließt und über den Darlingtonfolger T24, T25 das Gate des N-MOS-Transistors an PQ auflädt und weiterhin über die Kollektoren von T21, T22 die Basen von T104 ... T107 angesteuert werden, die wiederum Strom in die Basen von T21, T22 schicken. Die Schleife zündet durch; der Schalter für die High-Flanke ist aktiv. Strombegrenzend wirken nunmehr hauptsächlich die Bahnwiderstände der Transistoren und die induktiven Zuleitungen (Bound wire).

Um mit möglichst wenig Strom aus T101/T103 auszukommen, ist der Knoten 8 kapazitatsarm ausgeführt. Für das Layout der Schaltung nach Figur 2 bedeutet dies am Knoten 8 sehr kurze Leitungen im kapazitätsarmsten Metallager zu realisieren, um ein Starten der Transistoren in der Schleife T21/T22 T104/T107 schnell zu ermöglichen, die dann die weitere Aufladung vom Knoten 8 übernehmen.

Über die parasitären Kollektor-Basis-Kapazitäten wird während der High-Flanke ein Strom an die Basen von T15 ... T17 gebracht. Dieser Strom hätte einen Querstrom zur Folge, der durch C1, T18, T19 vermieden wird, da über C1, T18 (Siehe Figur 5c) angesteuert wird, der über seinen Kollektor den Strom an den Basen von T15 ... T17 in der High-Flanke von PQ nach PGND ableitet (Figur 5b). Die Ströme an den Basen von T12 und Knoten 22 werden über die Diode T11 und T10 nach GND abgeleitet, Spannungsverlauf in Figur 4a, 4b. Somit entsteht nur im Beginn der High-Flanke (bis die Basis von T18 über C1 angesteuert wird) ein geringer Querstrom (Figur 3c). Ist das Gate an PQ auf PVCC-2 UBE aufgeladen, wird der Strom in der Schleife T21, T22, T104 ... T107 zu Null. Der Treiber ist im High-Zustand. Es fließt nur der Strom in T 100,..,T103 und im Ansteuerblock, der Pegelumsetzung.

### Low-Flanke an PQ:

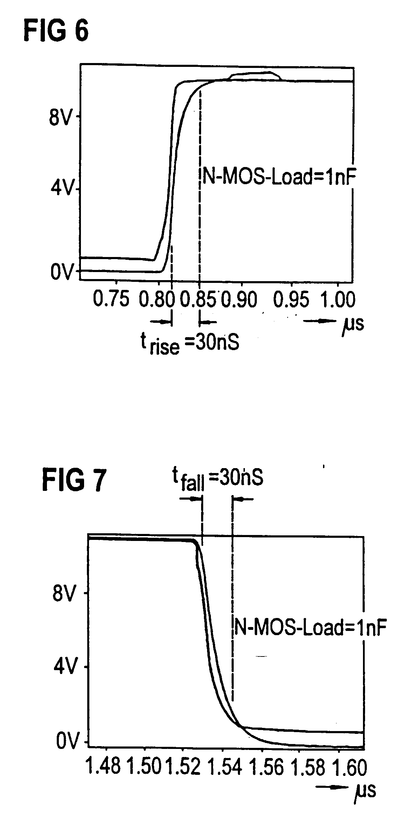

Wird die Basis von T10 durch den Kollektor von T9 gesperrt, fließt der Strom im 35 K-Widerstand in die Basis von T12, da der Kollektor von T10 hochohmig geworden ist. T12, T14, T15/T17 stellt eine Dreifach-Darlingtonanordnung dar, die bei Strom in die Basis an T12 auf PQ wirkt. Um in der Low-Flanke den Querstrom zu vermeiden, ist der Kollektor von T14 mit dem High-Flanken-Treiber verbunden und sorgt dafür, daß der Strom aus den Kollektoren T101/T103 abgeleitet wird. Weiterhin wird der Knoten am Emitter T21/T22 über die Diode T23 ausgeräumt. Hat der Kollektor T14 ein Potential PQ-UBE T20 erreicht, beteiligt er sich mit seinem Kollektorstrom am Treiben der kapazitiven Last am Knoten 6, PQ. T24/T25 sind nicht in der Lage, trotz einer schnellen Fall-Zeit an ihren Emittern Querstromanteile zu erbringen, da wegen der Diode T23 sich die Basen in der Flanke eine UBE unter den Emittern befinden (Figur 7). Die am schaltungsinternen Knoten 8 entstehenden parasitären Stromrückwirkungen auf den Knoten 9 werden durch einen 250 Ohm-Widerstand abgeleitet. Nach Beendigung der Low-Flanke bleibt der Low-Flanken-Treiber weiter aktiv, um Rückwirkungen vom Drain des externen N-MOS-Transistors auf das Gate nach PGND abzuleiten.

Um mit möglichst geringem Strom aus T101/T103 auszukommen, muß der Knoten 8 kapazitätsarm ausgeführt werden. Für das Layout der Schaltung nach Figur 1 bedeutet dies am Knoten 8 sehr kurze Leitungen zu realisieren, um ein Starten der Schleife T21/T22, T104/T107 schnell zu ermöglichen, die dann die weitere Aufladung vom Knoten 8 übernimmt.

In der Figur 3 sind ECL-Eingangssignalpegel (3a),N-MOS-Treiberausgangssignal (3b) und die Querströme des Treibers (3c) abgebildet.

In der Figur 4 sind in der Teilfigur 4a die Spannungsverläufe mit Überhöhung in der positiven Flanke am Knoten 22, in 4b der Spannungsverlauf am Knoten 4 sowie in 4c der Spannungsverlauf am Knoten 2 dargestellt.

In der Figur 5 ist in Fig. 5a der Spannungsverlauf am Knoten 9 dargestellt, in Fig. 5b und Fig. 5c der Spannungsverlauf am Knoten 4 und 6 wiedergegeben.

In Figur 6 sind die Spannungsverlaufe der positiven Flanke im Knoten 6 und 8 aufgezeigt.

In Figur 7 sind die Spannungsverlaufe der negativen Flanke im Knoten 6 und 8 wiedergegeben.

## Patentansprüche

1. Treiberschaltung (T) mit einem ersten Flankentreiber (HFT), der eine erste Ansteuereinheit (All) und eine mindestens einen ersten Transistor (T25) aufweisende erste Durchschalteeinheit (D1) zur Durchschaltung eines ersten Betriebspotentials (PVCC) an den Ausgang der Treiberschaltung (T) enthält und mit einem zweiten Flankentreiber, der eine zweite Ansteuereinheit (A21) und eine mindestens einen zweiten Transistor (T17) aufweisende zweite Durchschalteeinheit (D2) zur Durchschaltung eines zweiten Betriebspotentials (PGNG) an den Ausgang der Treiberschaltung (T) enthält, wobei der Emitter des ersten Transistors (T25) mit dem Kollektor des zweiten Transistors (T17) und einem Ausgang (PQ) der Treiberschaltung (T) verbunden ist,
**dadurch gekennzeichnet,**
daß die erste Ansteuereinheit (All) aus einer mindestens einen ersten Transistor (T103) enthaltenden Verstärkerstufe (All) und aus einer nachgeordneten Thyristorschaltung (T22, T107) gebildet ist,
daß die zweite Ansteuerschaltung (A21) aus einem ersten und zweiten Emitterfolger (T12, T14) gebildet ist,
daß der Kollektor des zweiten Emitterfolgers (T14) mit einem Kollektor des ersten Transistors (T103) der ersten Ansteuereinheit (A11) sowie über eine erste Diode (T23) mit der Basis des ersten Transistors (T25) verbunden ist,
daß die Kollektoren der Emitterfolger (T12, T14) außerdem über eine zweite und dritte Diode (T13, T20) mit dem Ausgang (PQ) der Treiberschaltung (T) verbunden sind und die Eingänge des ersten und zweiten Flankentreibers über einen Widerstand (R) miteinander verbunden sind und über einen der Eingänge (EHFT, ELFT) angesteuert werden.

2. Schaltungsanordnung nach Anspruch 1,
**dadurch gekennzeichnet,**
daß eine Teilschaltungseinheit (QH) mit einem weiteren Transistor (T18) vorgesehen ist, wobei an der Basis des weiteren Transistors (T18) eine Kapazität (C), eine Diode (T19) sowie ein Widerstand (RQ) angeschlossen ist,
daß der Kollektor des weiteren Transistors (T18) mit der Basis des zweiten Transistors (T17) verbunden ist,
daß die Kapazität (C) mit dem Kollektor des zweiten Transistors (T17) und der Emitter des weiteren Transistors (T18) verbunden ist und
daß der Emitter des weiteren Transistors (T18) und der zweite Anschluß der Diode (T19) sowie der zweite Anschluß des Widerstandes (RQ) mit dem zweiten Betriebspotential (PGND) verbunden ist.

3. Schaltungsanordnung nach einem der vorhergehenden Ansprüche,
daß während der aktiven Phase des zweiten Flankentreibers (LFT) dessen gesamte Flankentreiberleistung aktiv bleibt.

4. Schaltungsanordnung nach einem der vorhergehenden Ansprüche,
daß eine Pegelwandlerstufe (PU) am Eingang des zweiten Flankentreibers (ELFT) angeschlossen ist, wobei der Kollektor des Ausgangstransistors der Pegelwandlerstufe einen Open Kollektor aufweist und mit dem Eingang des zweiten Flankentreibers (ELFT) verbunden ist.

5. Schaltungsanordnung nach einem der vorhergehenden Ansprüche,
**dadurch gekennzeichnet,**
daß bei Anliegen einer Fehlermeldung (MOSOFF) an der Pegelwandlerstufe (PU) der zweite Flankentreiber (LFT) aktiviert wird und der erste Flankentreiber (HFT) deaktiviert wird.

## Claims

1. Driver circuit (T) having a first edge driver (HFT), which contains a first drive unit (A11) and a first switching-through unit (D1), which has at least one first transistor (T25) and is used for switching a first operating potential (PVCC) through to the output of the driver circuit (T), and having a second edge driver, which contains a second drive unit (A21) and a second switching-through unit (D2), which has at least one second transistor (T17) and is used for switching a second operating potential (PGND) through to the output of the driver circuit (T), the emitter of the first transistor (T25) being connected to the collector of the second transistor (T17) and to an output (PQ) of the driver circuit (T),
characterized
in that the first drive unit (A11) is formed from an amplifier stage (A11), which contains at least one first transistor (T103), and from a downstream thyristor circuit (T22, T107),
in that the second drive circuit (A21) is formed from a first and second emitter follower (T12, T14),
in that the collector of the second emitter follower (T14) is connected to a collector of the first transistor (T103) of the first drive unit (A11) and, via a first diode (T23), to the base of the first transistor (T25),
in that the collectors of the emitter followers (T12, T14) are additionally connected via a second and third diode (T13, T20) to the output (PQ) of the driver circuit (T), and the inputs of the first and second edge drivers are connected to one another via a resistor (R) and are driven via one of the inputs (EHFT, ELFT).

2. Circuit arrangement according to Claim 1,
characterized
in that a partial circuit unit (QH) having a further transistor (T18) is provided, a capacitor (C), a diode (T19) and a resistor (RQ) being connected to the base of the further transistor (T18),
in that the collector of the further transistor (T18) is connected to the base of the second transistor (T17),
in that the capacitor (C) is connected to the collector of the second transistor (T17), and
in that the emitter of the further transistor (T18) and the second terminal of the diode (T19) as well as the second terminal of the resistor (RQ) are connected to the second operating potential (PGND).

3. Circuit arrangement according to one of the preceding claims,
characterized
in that the entire edge driver power of the second edge driver (LFT) remains active during the active phase thereof.

4. Circuit arrangement according to one of the preceding claims,
characterized
in that a level converter stage (PU) is connected to the input of the second edge driver (ELFT), the collector of the output transistor of the level converter stage having an open collector and being connected to the input of the second edge driver (ELFT).

5. Circuit arrangement according to one of the preceding claims,
characterized
in that, when an error message (MOSOFF) is present at the level converter stage (PU), the second edge driver (LFT) is activated and the first edge driver (HFT) is deactivated.

## Revendications

1. Circuit d'attaque (T) comprenant un premier circuit d'attaque de flanc (HFT), qui comporte une première unité de commande (All) et une première unité de connexion (D1) comportant au moins un premier transistor (T25) et destinée à l'application d'un premier potentiel de fonctionnement (PVCC) à la sortie du circuit d'attaque (T) et un deuxième circuit d'attaque de flanc qui comporte une deuxième unité de commande (A21) et une deuxième unité de connexion (D2) comportant au moins un deuxième transistor (T17) et destinée à l'application d'un deuxième potentiel de fonctionnement (PGND) à la sortie du circuit d'attaque (T), l'émetteur du premier transistor (T25) étant relié au collecteur du deuxième transistor (T17) et à une sortie (PQ) du circuit d'attaque (T),
caractérisé par le fait que
la première unité de commande (A11) est formée d'un étage amplificateur (A11) contenant au moins un premier transistor (T103) et d'un circuit à thyristor (T22, T107) branché du côté aval,
la deuxième unité de commande (A21) est formée d'un premier émetteur-suiveur (T12) et d'un deuxième émetteur-suiveur (T14),
le collecteur du deuxième émetteur-suiveur (T14) est relié à un collecteur du premier transistor (T103) de la première unité de commande (A11) ainsi qu'à la base du premier transistor (T25) par l'intermédiaire d'une première diode (T23),
les collecteurs des émetteurs-suiveurs (T12, T14) sont aussi reliés par l'intermédiaire d'une deuxième diode (T13) et d'une troisième diode (T20) à la sortie (PQ) du circuit d'attaque (T) et les entrées du premier et du deuxième circuits d'attaque de flanc sont reliées ensemble par l'intermédiaire d'une résistance (R) et sont commandées par l'intermédiaire d'une des entrées (EHFT, ELFT).

2. Circuit selon la revendication 1,
caractérisé par le fait que
il est prévu un circuit partiel (QH) ayant un autre transistor (T18), une capacité (C), une diode (T19) et une résistance (RQ) étant raccordées à la base de l'autre transistor (T18),
le collecteur de l'autre transistor (T18) est relié à la base du deuxième transistor (T17),
la capacité (C) est reliée au collecteur du deuxième transistor (T17) et à l'émetteur de l'autre transistor (T18) et
l'émetteur de l'autre transistor (T18) et la deuxième borne de la diode (T19) ainsi que la deuxième borne de la résistance (RQ) sont reliés au deuxième potentiel de fonctionnement (PGND).

3. Circuit selon l'une des revendications précédentes,
caractérisé par le fait que, pendant la phase active du deuxième circuit d'attaque (LFT), la totalité de sa puissance d'attaque de flanc reste active.

4. Circuit selon l'une des revendications précédentes,
caractérisé par le fait qu'un étage convertisseur de niveau (PU) est raccordé à l'entrée (ELFT) du deuxième circuit d'attaque de flanc, le collecteur du transistor de sortie de l'étage convertisseur de niveau comportant un collecteur ouvert et étant relié à l'entrée (ELFT) du deuxième circuit d'attaque de flanc.

5. Circuit selon l'une des revendications précédentes,
caractérisé par le fait que, lorsqu'un message d'erreur (MOSOFF) est appliqué à l'étage convertisseur de niveau (PU), le deuxième circuit d'attaque de flanc (LFT) est activé et le premier circuit d'attaque de flanc (HFT) est désactivé.
